# EUROPEAN PATENT APPLICATION

(11) **EP 4 401 113 A1**
(43) Date of publication of application: **17.07.2024**
(21) Application number: 21956749.2
(22) Date of filing: 08.09.2021
(51) Int. Cl.: H01L 21/28, H01L 21/285, C23C 16/02, C23C 16/14, C23C 16/455

(54) **SEMICONDUCTOR DEVICE PRODUCTION METHOD, SUBSTRATE PROCESSING METHOD, SUBSTRATE PROCESSING DEVICE, AND RECORDING MEDIUM**

(71) Applicant: Kokusai Electric Corporation, Tokyo 101-0045 (JP)
(72) Inventor: KURIBAYASHI, Koei, Toyama-shi, Toyama 939-2393 (JP); OGAWA, Arito, Toyama-shi, Toyama 939-2393 (JP)
(74) Representative: Verscht, Thomas Kurt Albert
(86) International application number: PCT/JP2021/033031
(87) International publication number: WO 2023/037452

(57) **Abstract**

The present invention makes it possible to improve film characteristics of a metal-based film. The present invention comprises: (a) a step for supplying, to a substrate, a gas which contains a group 15 element, to form a first layer containing the group 15 element on the surface of the substrate; (b) a step for supplying, to the substrate, a gas which contains elemental Mo; (c) a step for supplying a reducing gas to the substrate; and (d) a step for carrying out (b) and (c) a prescribed number of times in an atmosphere in which decomposition of the first layer is suppressed, to form, on the first layer, a film which contains elemental Mo.

## Description

### [Technical Field]

The present disclosure relates to a method of manufacturing a semiconductor device, a substrate processing method, a substrate processing apparatus and a non-transitory computer-readable recording medium.

### [Related Art]

For example, a tungsten film (W film) whose resistance is low is used as a word line of a NAND flash memory (or a DRAM) of a three-dimensional structure. Further, for example, according to some related arts, a titanium nitride film (TiN film) serving as a barrier film may be used between the W film and an insulating film.

### [Related Art Document]

### [Patent Document]

Patent Document 1: Japanese Patent Laid-Open No. 2011-66263
Patent Document 2: International Patent Publication No. WO2019/058608

### [Disclosure]

### [Technical Problem]

However, as the number of layers in the NAND flash memory of the three-dimensional structure increases, it may be difficult to etch the layers. Thereby, it becomes difficult to make the word line thinner. In order to address such a problem described above, instead of forming the barrier film described above, there is a need for a method of forming a metal film whose characteristics is good.

It is an object of the present disclosure to provide a technique capable of improving characteristics of a metal-based film.

### [Technical Solution]

According to one embodiment of the present disclosure, there is provided a technique that includes:
(a) forming a first layer containing a Group 15 element on a surface of a substrate by supplying a gas containing the Group 15 element to the substrate; (b) supplying a gas containing molybdenum to the substrate;
(c) supplying a reducing gas to the substrate; and (d) forming a film containing molybdenum on the first layer by performing (b) and (c) a predetermined number of times in an atmosphere capable of suppressing a decomposition of the first layer.

### [Advantageous Effects]

According to some embodiments of the present disclosure, it is possible to improve characteristics of a metal-based film.

### [Brief Description of Drawings]

FIG. 1 is a diagram schematically illustrating a vertical cross-section of a vertical type process furnace of a substrate processing apparatus according to embodiments of the technique of the present disclosure.
FIG. 2 is a diagram schematically illustrating a horizontal cross-section taken along a line A-A (in FIG. 1) of the vertical type process furnace of the substrate processing apparatus according to the embodiments of the technique of the present disclosure.
FIG. 3 is a block diagram schematically illustrating a configuration of a controller and related components of the substrate processing apparatus according to the embodiments of the technique of the present disclosure.
FIG. 4 is a diagram schematically illustrating a substrate processing according to the embodiments of the technique of the present disclosure.
FIG. 5 is a diagram schematically illustrating a substrate processing according to a modified example of the embodiments of the technique of the present disclosure.
FIG. 6 is a diagram schematically illustrating a substrate processing according to another modified example of the embodiments of the technique of the present disclosure.
FIG. 7 is a diagram schematically illustrating a substrate processing according to another modified example of the embodiments of the technique of the present disclosure.
FIG. 8 is a diagram schematically illustrating a substrate processing according to another modified example of the embodiments of the technique of the present disclosure.

### [Detailed Description]

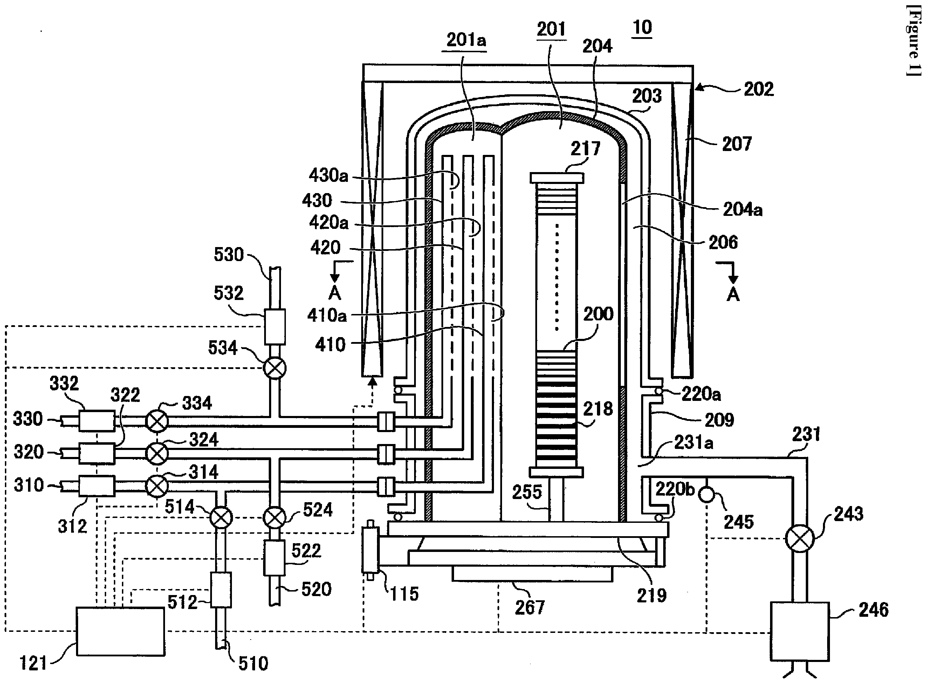

Hereinafter, embodiments according to the technique of the present disclosure will be described with reference to FIGS. 1 to 4. The drawings used in the following descriptions are all schematic. For example, a relationship between dimensions of each component and a ratio of each component shown in the drawing may not always match the actual ones. Further, even between the drawings, the relationship between the dimensions of each component and the ratio of each component may not always match.

### (1) Configuration of Substrate Processing Apparatus

A substrate processing apparatus 10 according to the present embodiments includes a process furnace 202 provided with a heater 207 serving as a heating structure (which is a heating device or a heating system). The heater 207 is of a cylindrical shape, and is vertically installed while being supported by a heater base (not shown) serving as a support plate.

An outer tube 203 constituting a reaction tube (which is a reaction vessel or a process vessel) is provided in an inner side of the heater 207 to be aligned in a manner concentric with the heater 207. For example, the outer tube 203 is made of a heat resistant material such as quartz (SiO₂) and silicon carbide (SiC). The outer tube 203 is of a cylindrical shape with a closed upper end and an open lower end. A manifold (which is an inlet flange) 209 is provided under the outer tube 203 to be aligned in a manner concentric with the outer tube 203. For example, the manifold 209 is made of a metal such as stainless steel (SUS). The manifold 209 is of a cylindrical shape with open upper and lower ends. An O-ring 220a serving as a seal is provided between the upper end of the manifold 209 and the outer tube 203. As the manifold 209 is supported by the heater base (not shown), the outer tube 203 is installed vertically.

An inner tube 204 constituting the reaction vessel is provided in an inner side of the outer tube 203. For example, the inner tube 204 is made of a heat resistant material such as quartz (SiO₂) and silicon carbide (SiC). The inner tube 204 is of a cylindrical shape with a closed upper end and an open lower end. The process vessel (reaction vessel) is constituted mainly by the outer tube 203, the inner tube 204 and the manifold 209. A process chamber 201 is provided in a hollow cylindrical portion of the process vessel (that is, an inside of the inner tube 204).

The process chamber 201 is configured to be capable of accommodating a plurality of wafers including a wafer 200 serving as a substrate in a horizontal orientation to be vertically arranged in a multistage manner by a boat 217 serving as a substrate support.

Nozzles 410, 420 and 430 are installed in the process chamber 201 so as to penetrate a side wall of the manifold 209 and the inner tube 204. Gas supply pipe 310, 320 and 330 are connected to the nozzles 410, 420 and 430, respectively. However, the process furnace 202 of the present embodiments is not limited to the example described above.

Mass flow controllers (MFCs) 312, 322 and 332 serving as flow rate controllers (flow rate control structures) and valves 314, 324 and 334 serving as opening/closing valves are sequentially installed at the gas supply pipes 310, 320 and 330 in this order from upstream sides to downstream sides of the gas supply pipes 310, 320 and 330, respectively. Gas supply pipes 510, 520 and 530 through which an inert gas is supplied are connected to the gas supply pipes 310, 320 and 330 at downstream sides of the valves 314, 324 and 334, respectively. MFCs 512, 522 and 532 serving as flow rate controllers (flow rate control structures) and valves 514, 524 and 534 serving as opening/closing valves are sequentially installed at the gas supply pipes 510, 520 and 530 in this order from upstream sides to downstream sides of the gas supply pipes 510, 520 and 530, respectively.

The nozzles 410, 420 and 430 are connected to front ends (tips) of the gas supply pipes 310, 320 and 330, respectively. Each of the nozzles 410, 420 and 430 may include an L-shaped nozzle. Horizontal portions of the nozzles 410, 420 and 430 are installed so as to penetrate the side wall of the manifold 209 and the inner tube 204. Vertical portions of the nozzles 410, 420 and 430 are installed in a preliminary chamber 201a of a channel shape (a groove shape) protruding outward in a radial direction of the inner tube 204 and extending in the vertical direction. That is, the vertical portions of the nozzles 410, 420 and 430 are installed in the preliminary chamber 201a toward the upper end of the inner tube 204 (in a direction in which the wafers 200 are arranged) and along an inner wall of the inner tube 204.

The nozzles 410, 420 and 430 extend from a lower region of the process chamber 201 to an upper region of the process chamber 201. The nozzles 410, 420 and 430 are provided with a plurality of gas supply holes 410a, a plurality of gas supply holes 420a and a plurality of gas supply holes 430a facing the wafers 200, respectively. Thereby, a gas such as a process gas can be supplied to the wafers 200 through the gas supply holes 410a of the nozzle 410, the gas supply holes 420a of the nozzle 420 and the gas supply holes 430a of the nozzle 430. The gas supply holes 410a, the gas supply holes 420a and the gas supply holes 430a are provided from a lower portion to an upper portion of the inner tube 204. An opening area of each of the gas supply holes 410a, the gas supply holes 420a and the gas supply holes 430a is the same, and each of the gas supply holes 410a, the gas supply holes 420a and the gas supply holes 430a is provided at the same pitch. However, the gas supply holes 410a, the gas supply holes 420a and the gas supply holes 430a are not limited thereto. For example, the opening area of each of the gas supply holes 410a, the gas supply holes 420a and the gas supply holes 430a may gradually increase from the lower portion to the upper portion of the inner tube 204 to further uniformize a flow rate of the gas supplied through the gas supply holes 410a, the gas supply holes 420a and the gas supply holes 430a.

The gas supply holes 410a of the nozzle 410, the gas supply holes 420a of the nozzle 420 and the gas supply holes 430a of the nozzle 430 are provided from a lower portion to an upper portion of the boat 217 described later. Therefore, the process gas supplied into the process chamber 201 through the gas supply holes 410a, the gas supply holes 420a and the gas supply holes 430a is supplied onto the wafers 200 accommodated in the boat 217 from the lower portion to the upper portion thereof, that is, the entirety of the wafers 200 accommodated in the boat 217. It is preferable that the nozzles 410, 420 and 430 extend from the lower region to the upper region of the process chamber 201. However, the nozzles 410, 420 and 430 may extend only to the vicinity of a ceiling of the boat 217.

A source gas containing a metal element (also referred to as a "metal-containing gas") and serving as one of process gases is supplied into the process chamber 201 through the gas supply pipe 310 provided with the MFC 312 and the valve 314 and the nozzle 410.

A reducing gas serving as one of the process gases is supplied into the process chamber 201 through the gas supply pipe 320 provided with the MFC 322 and the valve 324 and the nozzle 420.

A gas containing a Group 15 element, serving as one of the process gases and different from the reducing gas is supplied into the process chamber 201 through the gas supply pipe 330 provided with the MFC 332 and the valve 334 and the nozzle 430.

The inert gas such as argon (Ar) gas is supplied into the process chamber 201 through the gas supply pipes 510, 520 and 530 provided with the MFCs 512, 522 and 532 and the valves 514, 524 and 534, respectively, and the nozzles 410, 420 and 430. While the present embodiments will be described by way of an example in which the argon gas is used as the inert gas, the inert gas according to the present embodiments is not limited thereto. For example, instead of the argon gas, a rare gas such as helium (He) gas, neon (Ne) gas and xenon (Xe) gas may be used as the inert gas.

When the source gas is supplied through the gas supply pipe 310, a source gas supplier (which is a source gas supply structure or a source gas supply system) is constituted mainly by the gas supply pipe 310, the MFC 312 and the valve 314. The source gas supplier may further include the nozzle 410. The source gas supplier may also be referred to as a "metal-containing gas supplier" which is a metal-containing gas supply structure or a metal-containing gas supply system. Further, when the reducing gas is supplied through the gas supply pipe 320, a reducing gas supplier (which is a reducing gas supply structure or a reducing gas supply system) is constituted mainly by the gas supply pipe 320, the MFC 322 and the valve 324. The reducing gas supplier may further include the nozzle 420. Further, when the gas containing the Group 15 element is supplied through the gas supply pipe 330, a Group 15 element-containing gas supplier (which is a Group 15 element-containing gas supply structure or a Group 15 element-containing gas supply system) is constituted mainly by the gas supply pipe 330, the MFC 332 and the valve 334. The Group 15 element-containing gas supplier may further include the nozzle 430. A process gas supplier (which is a process gas supply structure or a process gas supply system) is constituted by the metal-containing gas supplier, the reducing gas supplier and the Group 15 element-containing gas supplier. Further, the process gas supplier may further include the nozzles 410, 420 and 430. In addition, an inert gas supplier (which is an inert gas supply structure or an inert gas supply system) is constituted mainly by the gas supply pipes 510, 520 and 530, the MFCs 512, 522 and 532 and the valves 514, 524 and 534.

According to the present embodiments, the gas is supplied into a vertically long annular space which is defined by the inner wall of the inner tube 204 and edges (peripheries) of the wafers 200 through the nozzles 410, 420 and 430 provided in the preliminary chamber 201a. The gas is ejected into the inner tube 204 through the gas supply holes 410a of the nozzle 410, the gas supply holes 420a of the nozzle 420 and the gas supply holes 430a of the nozzle 430 facing the wafers 200. Specifically, gases such as the source gas are ejected into the inner tube 204 in a direction parallel to surfaces of the wafers 200 through the gas supply holes 410a of the nozzle 410, the gas supply holes 420a of the nozzle 420 and the gas supply holes 430a of the nozzle 430, respectively.

An exhaust hole (which is an exhaust port) 204a is a through-hole facing the nozzles 410, 420 and 430, and is provided at a side wall of the inner tube 204. For example, the exhaust hole 204a may be of a narrow slit-shaped through-hole elongating vertically. The gas supplied into the process chamber 201 through the gas supply holes 410a of the nozzle 410, the gas supply holes 420a of the nozzle 420 and the gas supply holes 430a of the nozzle 430 flows over the surfaces of the wafers 200. The gas that has flowed over the surfaces of the wafers 200 is exhausted through the exhaust hole 204a into a gap (that is, an exhaust path 206) provided between the inner tube 204 and the outer tube 203. The gas flowing in the exhaust path 206 flows into an exhaust pipe 231 and is then discharged (exhausted) out of the process furnace 202.

The exhaust hole 204a is provided to face the wafers 200. The gas supplied in the vicinity of the wafers 200 in the process chamber 201 through the gas supply holes 410a, the gas supply holes 420a and the gas supply holes 430a flows in the horizontal direction. The gas that has flowed in the horizontal direction is exhausted through the exhaust hole 204a into the exhaust path 206. The exhaust hole 204a is not limited to the slit-shaped through-hole. For example, the exhaust hole 204a may be configured as a plurality of holes.

The exhaust pipe 231 through which an inner atmosphere of the process chamber 201 is exhausted is installed at the manifold 209. A pressure sensor 245 serving as a pressure detector (pressure detecting structure) configured to detect an inner pressure of the process chamber 201, an APC (Automatic Pressure Controller) valve 243 and a vacuum pump 246 serving as a vacuum exhaust apparatus are sequentially installed at the exhaust pipe 231 in this order from an upstream side to a downstream side of the exhaust pipe 231. With the vacuum pump 246 in operation, the APC valve 243 may be opened or closed to perform a vacuum exhaust of the process chamber 201 or stop the vacuum exhaust. Further, with the vacuum pump 246 in operation, an opening degree of the APC valve 243 may be adjusted in order to adjust the inner pressure of the process chamber 201. An exhauster (which is an exhaust structure or an exhaust system) is constituted mainly by the exhaust hole 204a, the exhaust path 206, the exhaust pipe 231, the APC valve 243 and the pressure sensor 245. The exhauster may further include the vacuum pump 246.

A seal cap 219 serving as a furnace opening lid capable of airtightly sealing a lower end opening of the manifold 209 is provided under the manifold 209. The seal cap 219 is in contact with the lower end of the manifold 209 from thereunder. For example, the seal cap 219 is made of a metal such as SUS, and is of a disk shape. An O-ring 220b serving as a seal is provided on an upper surface of the seal cap 219 so as to be in contact with the lower end of the manifold 209. A rotator 267 configured to rotate the boat 217 accommodating the wafers 200 is provided at the seal cap 219 in a manner opposite to the process chamber 201. A rotating shaft 255 of the rotator 267 is connected to the boat 217 through the seal cap 219. As the rotator 267 rotates the boat 217, the wafers 200 are rotated. The seal cap 219 may be elevated or lowered in the vertical direction by a boat elevator 115 serving as an elevating structure vertically provided outside the outer tube 203. When the seal cap 219 is elevated or lowered in the vertical direction by the boat elevator 115, the boat 217 may be transferred (loaded) into the process chamber 201 or transferred (unloaded) out of the process chamber 201. The boat elevator 115 serves as a transfer device (which is a transfer structure or a transfer system) that loads the boat 217 and the wafers 200 accommodated in the boat 217 into the process chamber 201 or unloads the boat 217 and the wafers 200 accommodated in the boat 217 out of the process chamber 201.

The boat 217 is configured to accommodate (or support) the wafers 200 (for example, 25 to 200 wafers) while the wafers 200 are horizontally oriented with their centers aligned with one another with a predetermined interval therebetween in a vertical direction. For example, the boat 217 is made of a heat resistant material such as quartz and SiC. A plurality of dummy substrates 218 horizontally oriented are placed under the boat 217 in a multistage manner. Each of the dummy substrates 218 is made of a heat resistant material such as quartz and SiC. With such a configuration, the dummy substrates 218 suppress the transmission of the heat from the heater 207 to the seal cap 219. However, the present embodiments are not limited thereto. For example, instead of the dummy substrates 218, a heat insulating cylinder (not shown) such as a cylinder made of a heat resistant material such as quartz and SiC may be provided under the boat 217.

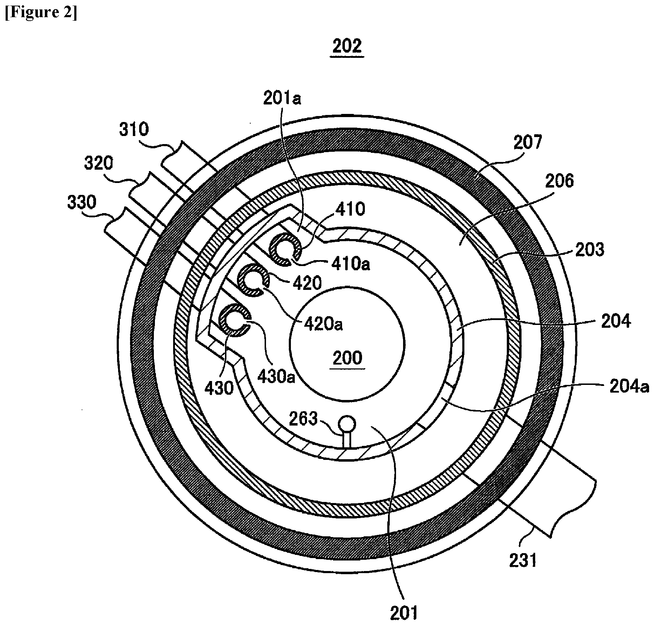

As shown in FIG. 2, a temperature sensor 263 serving as a temperature detector is installed in the inner tube 204. An amount of the current supplied (or applied) to the heater 207 is adjusted based on temperature information detected by the temperature sensor 263 such that a desired temperature distribution of an inner temperature of the process chamber 201 can be obtained. Similar to the nozzles 410, 420 and 430, the temperature sensor 263 is L-shaped, and is provided along the inner wall of the inner tube 204.

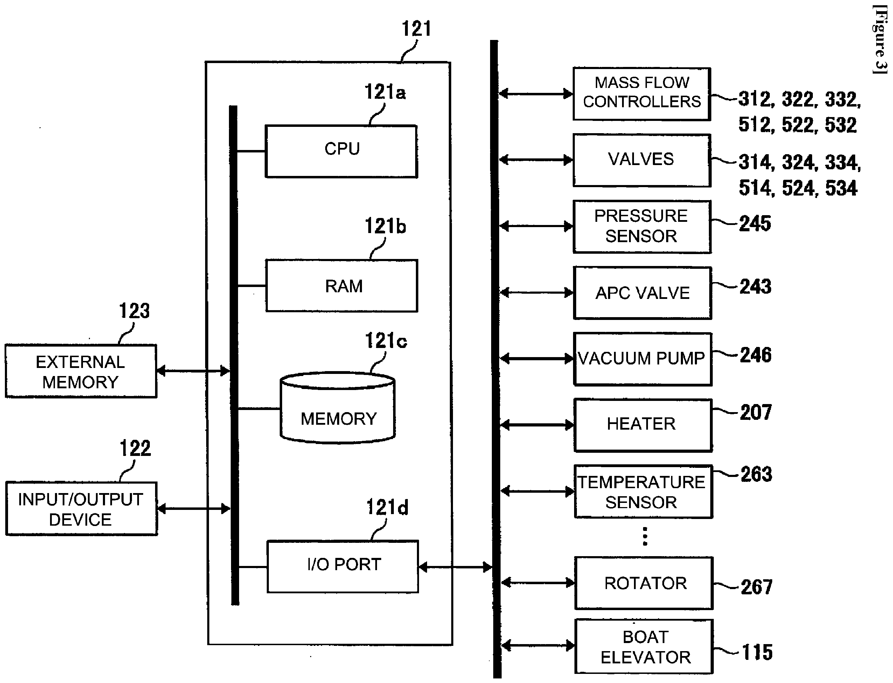

As shown in FIG. 3, a controller 121 serving as a control device (or a control structure) is constituted by a computer including a CPU (Central Processing Unit) 121a, a RAM (Random Access Memory) 121b, a memory 121c and an I/O port 121d. The RAM 121b, the memory 121c and the I/O port 121d may exchange data with the CPU 121a through an internal bus (not shown). For example, an input/output device 122 constituted by a component such as a touch panel is connected to the controller 121.

The memory 121c is configured by a component such as a flash memory and a hard disk drive (HDD). For example, a control program configured to control an operation of the substrate processing apparatus 10 or a process recipe containing information on sequences and conditions of a method of manufacturing a semiconductor device (that is, a substrate processing method) described later is readably stored in the memory 121c. The process recipe is obtained by combining steps of the method of manufacturing the semiconductor device (substrate processing method) described later such that the controller 121 can execute the steps to acquire a predetermined result, and functions as a program. Hereafter, the process recipe and the control program may be collectively or individually referred to as a "program". In the present specification, the term "program" may refer to the process recipe alone, may refer to the control program alone, or may refer to a combination of the process recipe and the control program. The RAM 121b functions as a memory area (work area) where a program or data read by the CPU 121a is temporarily stored.

The I/O port 121d is connected to the components described above such as the MFCs 312, 322, 332, 512, 522 and 532, the valves 314, 324, 334, 514, 524 and 534, the pressure sensor 245, the APC valve 243, the vacuum pump 246, the heater 207, the temperature sensor 263, the rotator 267 and the boat elevator 115.

The CPU 121a is configured to read the control program from the memory 121c and execute the read control program. In addition, the CPU 121a is configured to read a recipe such as the process recipe from the memory 121c in accordance with an operation command inputted from the input/output device 122. In accordance with the contents of the read recipe, the CPU 121a may be configured to control various operations such as flow rate adjusting operations for various gases by the MFCs 312, 322, 332, 512, 522 and 532, opening and closing operations of the valves 314, 324, 334, 514, 524 and 534, an opening and closing operation of the APC valve 243, a pressure adjusting operation by the APC valve 243 based on the pressure sensor 245, a temperature adjusting operation by the heater 207 based on the temperature sensor 263, a start and stop of the vacuum pump 246, an operation of adjusting a rotation and a rotation speed of the boat 217 by the rotator 267, an elevating and lowering operation of the boat 217 by the boat elevator 115 and an operation of transferring and accommodating the wafer 200 into the boat 217.

The controller 121 may be embodied by installing the above-described program stored in an external memory 123 into a computer. For example, the external memory 123 may include a magnetic tape, a magnetic disk such as a flexible disk and a hard disk, an optical disk such as a CD and a DVD, a magneto-optical disk such as an MO and a semiconductor memory such as a USB memory and a memory card. The memory 121c or the external memory 123 may be embodied by a non-transitory computer readable recording medium. Hereafter, the memory 121c and the external memory 123 are collectively or individually referred to as a "recording medium". In the present specification, the term "recording medium" may refer to the memory 121c alone, may refer to the external memory 123 alone, and may refer to both of the memory 121c and the external memory 123. Instead of the external memory 123, a communication structure such as the Internet and a dedicated line may be used for providing the program to the computer.

### (2) Substrate Processing

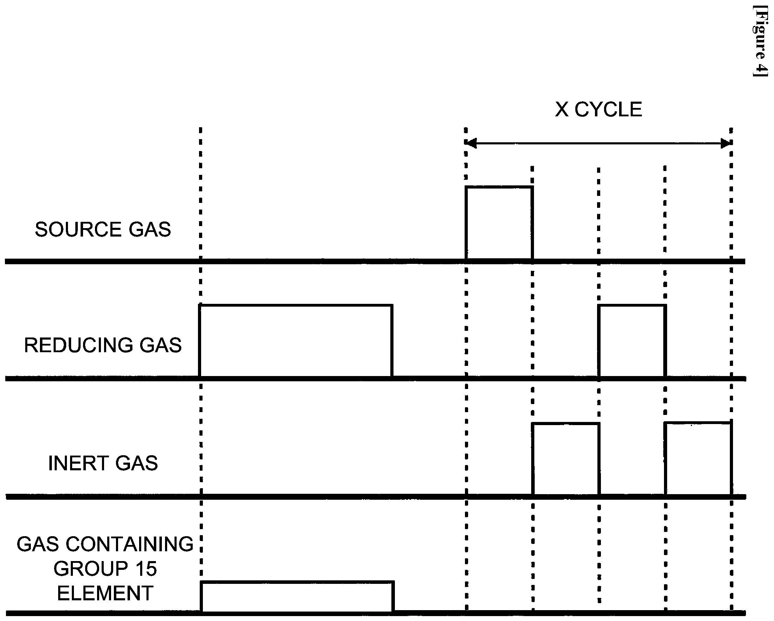

Hereinafter, as a part of a manufacturing process of a semiconductor device, an exemplary substrate processing of forming a film containing molybdenum (Mo) (hereinafter, also referred to as a "molybdenum-containing film" (or a "Mo-containing film") on the wafer 200 will be described with reference to FIG. 4. For example, the Mo-containing film is used as a control gate electrode of a NAND flash memory of a three-dimensional structure. The substrate processing of forming the Mo-containing film is performed by using the process furnace 202 of the substrate processing apparatus 10 described above. In the following description, operations of the components constituting the substrate processing apparatus 10 are controlled by the controller 121.

In the substrate processing (that is, the manufacturing process of the semiconductor device) according to the present embodiments, it is possible to form the Mo-containing film serving as a metal-containing film on the first layer of the wafer 200 by performing: (A) forming a first layer containing the Group 15 element on a surface of the wafer 200 by supplying the gas containing the Group 15 element to the wafer 200; and (B) forming a film containing Mo element on the first layer by performing (a) supplying a gas containing the Mo element to the wafer 200 and (b) supplying the reducing gas to the wafer 200 a predetermined number of times in an atmosphere capable of suppressing a decomposition of the first layer.

In the present specification, the term "wafer" may refer to "a wafer itself', may refer to "a wafer and a stacked structure (aggregated structure) of a predetermined layer (or layers) or a film (or films) formed on a surface of the wafer". In the present specification, the term "a surface of a wafer" may refer to "a surface of a wafer itself', may refer to "a surface of a predetermined layer or a film formed on a wafer". In the present specification, the term "substrate" and "wafer" may be used as substantially the same meaning.

### <Wafer Loading Step>

The wafers 200 are charged (transferred) into the boat 217 (wafer charging step). After the boat 217 is charged with the wafers 200, as shown in FIG. 1, the boat 217 charged with the wafers 200 is elevated by the boat elevator 115 and loaded (transferred) into the process chamber 201 to be accommodated therein (boat loading step). With the boat 217 loaded, the seal cap 219 seals the lower end opening of the outer tube 203 via the O-ring 220b.

### <Pressure Adjusting Step and Temperature Adjusting Step>

The vacuum pump 246 vacuum-exhausts the inner atmosphere of the process chamber 201 such that the inner pressure of the process chamber 201 (that is, a pressure in a space in which the wafers 200 are accommodated) reaches and is maintained at a desired pressure (vacuum degree). Meanwhile, the inner pressure of the process chamber 201 is measured by the pressure sensor 245, and the APC valve 243 is feedback-controlled based on measured pressure information (pressure adjusting step). The vacuum pump 246 continuously vacuum-exhausts the inner atmosphere of the process chamber 201 until at least a processing of the wafer 200 is completed. The heater 207 heats the process chamber 201 such that the inner temperature of the process chamber 201 reaches and is maintained at a desired temperature. Meanwhile, the amount of the current supplied to the heater 207 is feedback-controlled based on the temperature information detected by the temperature sensor 263 such that the desired temperature distribution of the inner temperature of the process chamber 201 is obtained (temperature adjusting step). The heater 207 continuously heats the process chamber 201 until at least the processing of the wafer 200 is completed.

### [First Layer Forming Step]

### [First Step]

### <Pre-Treatment Step and Gas Containing Group 15 Element Supply Step>

The valve 334 is opened to supply the gas containing the Group 15 element into the gas supply pipe 330. A flow rate of the gas containing the Group 15 element supplied into the gas supply pipe 330 is adjusted by the MFC 332. The gas containing the Group 15 element whose flow rate is adjusted is then supplied into the process chamber 201 through the gas supply holes 430a of the nozzle 430, and is exhausted through the exhaust pipe 231. Thereby, the gas containing the Group 15 element is supplied to the wafers 200. In the present step, the valve 534 may be opened to supply the inert gas such as the argon gas into the gas supply pipe 530. A flow rate of the argon gas supplied into the gas supply pipe 530 is adjusted by the MFC 532. The argon gas whose flow rate is adjusted is then supplied into the process chamber 201 together with the gas containing the Group 15 element, and is exhausted through the exhaust pipe 231. In the present step, in order to prevent the gas containing the Group 15 element from entering the nozzles 410 and 420, the valves 514 and 524 are opened to supply the argon gas into the gas supply pipes 510 and 520. The argon gas is then supplied into the process chamber 201 through the gas supply pipes 310 and 320 and nozzles 410 and 420, and is exhausted through the exhaust pipe 231.

In the present step, for example, the APC valve 243 is appropriately adjusted (or controlled) such that the inner pressure of the process chamber 201 can be set to a pressure within a range from 1 Pa to 3,990 Pa. For example, the inner pressure of the process chamber 201 is set to 1,000 Pa by adjusting the APC valve 243. For example, a supply flow rate of the gas containing the Group 15 element controlled by the MFC 332 can be set to a flow rate within a range from 0.01 slm to 5.0 slm. For example, each supply flow rate of the argon gas controlled by each of the MFCs 512, 522 and 532 supplied to prevent the gas containing the Group 15 element from entering each nozzle can be set to a flow rate within a range from 0.1 slm to 5.0 slm. In the present step, for example, a temperature of the heater 207 can be set such that a temperature of the wafer 200 reaches and is maintained at a temperature within a range from 300 °C to 650 °C. The temperature of the wafer 200 in the present step is preferably set to be lower than or equal to the temperature of the wafer 200 in a metal-containing film forming step described later. In the present specification, a notation of a numerical range such as "from 1 Pa to 3,990 Pa" means that a lower limit and an upper limit are included in the numerical range. Therefore, for example, the numerical range "from 1 Pa to 3,990 Pa" means a range equal to or higher than 1 Pa and equal to or lower than 3,990 Pa. The same also applies to other numerical ranges described herein.

### <Step of Supplying At Least One Among Dilution Gas and Reducing Gas>

In addition, while the gas containing the Group 15 element is being supplied, a timing for supplying at least one among a dilution gas and the reducing gas is provided. In the present embodiments, as the dilution gas, a reducing gas may be used in addition to the inert gas. Preferably, a gas whose property is capable of suppressing a change in a state of a Group 15 element-containing material or a decomposition of the Group 15 element-containing material may be used. By supplying such a gas as the dilution gas into the process chamber 201, an atmosphere where the change in the state of the Group 15 element-containing material or the decomposition of the Group 15 element-containing material is suppressed can be provided in the process chamber 201. To supply such gases, specifically, the valve 324 is opened to supply the reducing gas serving as the dilution gas into the gas supply pipe 320. A flow rate of the reducing gas supplied into the gas supply pipe 320 is adjusted by the MFC 322. The reducing gas whose flow rate is adjusted is then supplied into the process chamber 201 through the gas supply holes 420a of the nozzle 420, and is exhausted through the exhaust pipe 231. Thereby, the gas containing the Group 15 element and the reducing gas serving as the dilution gas are supplied to the wafers 200. In the present step, in parallel with a supply of the gas containing the Group 15 element and a supply of the reducing gas, the valve 524 may be opened to supply the inert gas such as the argon gas into the gas supply pipe 520. The flow rate of the argon gas supplied into the gas supply pipe 520 is adjusted by the MFC 522. The argon gas whose flow rate is adjusted is then supplied into the process chamber 201 together with the reducing gas, and is exhausted through the exhaust pipe 231. For example, when the inert gas alone is supplied as the dilution gas, the valve 324 may be closed to supply the inert gas through another inert gas supplier.

### <Step of Adjusting Concentration of Group 15 Element-Containing Material>

Further, in order to adjust a concentration of the Group 15 element-containing material supplied to the wafer 200 to a predetermined concentration, the dilution gas may be supplied. The gas containing the Group 15 element may be a gas constituted by a simple substance of the Group 15 element, or may be a mixture of the gas of the material containing the Group 15 element and the dilution gas. In each case, at least one among the flow rate of the gas containing the Group 15 element, the flow rate of the reducing gas and the flow rate of the dilution gas is adjusted accordingly so as to achieve a predetermined concentration. In the present step, the flow rate of each gas is adjusted such that, for example, the concentration of the Group 15 element-containing material (that is, the gas containing the Group 15 element) is adjusted to a concentration within a range from of 0.1 % to 50 %. By supplying the gas at such a concentration, it is possible to form the first layer containing the Group 15 element. Further, it is possible to suppress (prevent) a concentration of the Group 15 elements in a metal film (Mo-containing film) formed on the first layer from increasing. In addition, when the concentration described above is less than 0.1 %, it may be difficult to form the first layer containing the Group 15 element, and it may potentially reduce a manufacturing throughput since a time for forming the first layer may increase. In addition, when the concentration described above is greater than 50 %, the concentration of the Group 15 elements in the first layer may increase, and the concentration of Group 15 elements in the metal film (Mo-containing film) may also increase. Thereby, characteristics of the metal film may deteriorate. In addition, by supplying the gas whose concentration is greater than 50 %, an amount of decomposition products of the Group 15 element-containing material generated in the process chamber 201 may increase, and a ratio of the Group 15 elements and other elements (for example, hydrogen) in the first layer may not meet a specified ratio. In such a case, it may be difficult to obtain effects described in the present disclosure.

In the present step, the gas supplied into the process chamber 201 is at least the gas containing the Group 15 element. In the present specification, the Group 15 element is at least one selected from the group of phosphorus (P) and arsenic (As). In the present specification, the gas containing the Group 15 element is a gas containing at least one selected from the group of phosphorus and arsenic. Further, preferably, the gas containing the Group 15 element may contain hydrogen (H). As a gas containing phosphorus and hydrogen, for example, an alkylphosphine-based gas such as trimethylphosphine ((CH₃)₃P) gas, triethylphosphine ((C₂H₅)₃P) gas, trinormalpropylphosphine ((n-C₃H₇)₃P) gas, triisopropylphosphine ((i-C₃H₇)₃P) gas, trinormalbutylphosphine ((n-C₄H₉)₃P) gas, triisobutylphosphine ((i-C₄H₉)₃P) gas, tritertiarybutylphosphine ((t-C₄H₉)₃P) gas and tertiarybutylphosphine (t-C₄H₉PH₂) gas, an aminophosphine-based gas such as aminophosphine (NH₂PH₂) gas, tris (dimethylamino) phosphine ((CH₃)₂N)]₃P) gas, bis (dimethylamino) phosphine (PH(N(CH₃)₂)₂) gas and bis (dimethylamino) chlorophosphine (((CH₃)₂N)₂PCl) gas, a phosphinamide-based gas such as bis (dimethylamino) methylphosphine (CH₃P(N(CH₃)₂)₂) gas, dimethylaminodimethylphosphine ((CH₃)₂PN(CH₃)₂) gas and diethylaminodiethylphosphine ((C₂H₅)₂PN(C₂H₅)₂) gas, a phosphine-based gas such as phosphine (PH₃) gas and diphosphine (P₂H₄) gas, or a gas such as trivinylphosphine ((CH₂=CH)₃P) gas may be used. Further, at least one among the materials exemplified above may be used as the Group 15 element-containing material. For example, the Group 15 element-containing gas may be a single gas of the Group 15 element-containing material, or may be a mixed gas of the Group 15 element-containing material and the dilution gas.

By supplying such a gas to the wafer 200, the first layer containing at least phosphorus is formed on the surface of the wafer 200. Preferably, the first layer is a layer containing phosphorus and hydrogen. More preferably, the first layer is a layer containing molecules of the Group 15 element-containing material or partially decomposed molecules of the Group 15 element-containing material. For example, the first layer formed when the PH₃ is used as the Group 15 element-containing material may contain phosphorus (P), hydrogen (H) and PHₓ. In the present embodiments, X is an integer of 3 or less. For example, the PHx is at least one selected from the group of PH, PH₂ and PH₃. Further, in order to form the first layer containing such a substance, it is preferable that the inner temperature of the process chamber 201 is set to a temperature at which a part of the Group 15 element-containing material is capable of being decomposed. For example, when the PH₃ is used as the Group 15 element-containing material, the inner temperature of the process chamber 201 is set to a temperature within a range from 300 °C to 650 °C.

### [Second Step]

### <Residual Gas Removing Step>

After a predetermined time (for example, from 1 second to 600 seconds) has elapsed from the supply of the gas containing the Group 15 element, the valve 334 of the gas supply pipe 330 is closed to stop the supply of the gas containing the Group 15 element. That is, for example, a supply time (time duration) of supplying the gas containing the Group 15 element to the wafer 200 is set to a time within a range from 1 second to 600 seconds. In the present step, with the APC valve 243 of the exhaust pipe 231 open, the vacuum pump 246 vacuum-exhausts the inner atmosphere of the process chamber 201 to remove a residual gas in the process chamber 201 such as the gas containing the Group 15 element which remains unreacted already contributed to a formation of the first layer from the process chamber 201. That is, the inner atmosphere of the process chamber 201 is exhausted. By lowering the inner pressure of the process chamber 201, it is possible to exhaust the gas containing the Group 15 element remaining in the gas supply pipe 330 and the nozzle 430. By exhausting the gas containing the Group 15 element remaining in the gas supply pipe 330 and the nozzle 430, in a metal-containing film forming step described later, it is possible to suppress (prevent) the gas containing the Group 15 element remaining in the gas supply pipe 330 and the nozzle 430 from being supplied into the process chamber 201. Further, in the present step, by maintaining the valves 514, 524 and 534 open, the argon gas may be continuously supplied into the process chamber 201. In addition to serving as a gas capable of suppressing the gas containing the Group 15 element from entering each nozzle, the argon gas also serves as a purge gas. When the argon gas serving as the purge gas is supplied, it is possible to improve an efficiency of removing the residual gas in the process chamber 201 such as the gas containing the Group 15 element which remains unreacted or already contributed to a formation of the first layer from the process chamber 201.

### [Metal-containing Film Forming Step]

### [Third Step]

### <Metal-containing Gas Supply Step>

Subsequently, the valve 314 is opened to supply the metal-containing gas serving as the source gas into the gas supply pipe 310. A flow rate of the metal-containing gas supplied into the gas supply pipe 310 is adjusted by the MFC 312. The metal-containing gas whose flow rate is adjusted is then supplied into the process chamber 201 through the gas supply holes 410a of the nozzle 410, and is exhausted through the exhaust pipe 231. Thereby, the metal-containing gas is supplied to the wafers 200. In the present step, in parallel with a supply of the metal-containing gas, the valve 514 is opened to supply the inert gas such as the argon gas into the gas supply pipe 510. The flow rate of the argon gas supplied into the gas supply pipe 510 is adjusted by the MFC 512. The argon gas whose flow rate is adjusted is then supplied into the process chamber 201 together with the metal-containing gas, and is exhausted through the exhaust pipe 231. In the present step, in order to prevent the metal-containing gas from entering the nozzles 420 and 430, the valves 524 and 534 are opened to supply the argon gas into the gas supply pipes 520 and 530. The argon gas is then supplied into the process chamber 201 through the gas supply pipes 320 and 330 and nozzles 420 and 430, and is exhausted through the exhaust pipe 231.

In the present step, for example, the APC valve 243 is appropriately adjusted (or controlled) such that the inner pressure of the process chamber 201 can be set to a pressure within a range from 1 Pa to 3,990 Pa. For example, the inner pressure of the process chamber 201 is set to 500 Pa by adjusting the APC valve 243. For example, a supply flow rate of the metal-containing gas controlled by the MFC 312 can be set to a flow rate within a range from 0.1 slm to 1.0 slm. For example, each supply flow rate of the argon gas controlled by each of the MFCs 512, 522 and 532 can be set to a flow rate within a range from 0.1 slm to 5.0 slm. In the present step, for example, the temperature of the heater 207 can be set such that the temperature of the wafer 200 reaches and is maintained at a temperature within a range from 300 °C to 650 °C.

In the present step, the metal-containing gas serves as a primary gas (main gas) supplied into the process chamber 201 (that is, to the wafers 200). That is, the metal-containing gas is supplied to the wafers 200. According to the present embodiments, as the metal-containing gas, for example, a gas containing molybdenum (Mo) as the metal element (hereinafter, also referred to as a molybdenum-containing gas" (or a "Mo-containing gas")) may be used. As the Mo-containing gas, for example, a gas containing molybdenum (Mo) and chlorine (Cl) such as molybdenum pentachloride (MoCl₅) gas, a gas containing molybdenum (Mo), oxygen (O) and chlorine (Cl) such as molybdenum dioxide dichloride (MoO₂Cl₂) gas and molybdenum tetrachloride oxide (MoOCl₄) gas may be used. By supplying the Mo-containing gas, a molybdenum-containing layer (also referred to as a "Mo-containing layer") serving as a metal-containing layer is formed on the wafer 200 (that is, the first layer). When the MoCl₅ gas is used, the Mo-containing layer may be a molybdenum layer containing chlorine (Cl) or an adsorption layer of the MoCl₅ gas. Further, when the MoO₂Cl₂ gas (or the MoOCl₄ gas) is used, the Mo-containing layer may be a molybdenum layer containing chlorine (Cl) or oxygen (O), may be an adsorption layer of the MoO₂Cl₂ gas (or the MoOCl₄ gas), or may be both of the molybdenum layer containing chlorine (Cl) or oxygen (O) and the adsorption layer of the MoO₂Cl₂ gas (or the MoOCl₄ gas). Further, preferably, the molybdenum layer is a layer containing phosphorus (P) contained in the first layer. For example, when the first layer contains phosphorus (P), hydrogen (H) or the PHₓ, the Mo-containing gas reacts with the molecules constituting the first layer. Thereby, the elements and molecules constituting the first layer are desorbed from the first layer. During such a desorption process, it is possible to incorporate the elements and molecules constituting the first layer into the molybdenum layer.

### [Fourth Step]

### <Residual Gas Removing Step>

After a predetermined time (for example, from 1 second to 60 seconds) has elapsed from the supply of the metal-containing gas, the valve 314 of the gas supply pipe 310 is closed to stop the supply of the metal-containing gas. That is, for example, a supply time (time duration) of supplying the metal-containing gas to the wafer 200 is set to a time within a range from 1 second to 60 seconds. In the present step, with the APC valve 243 of the exhaust pipe 231 open, the vacuum pump 246 vacuum-exhausts the inner atmosphere of the process chamber 201 to remove a residual gas in the process chamber 201 such as the metal-containing gas which remains unreacted or already contributed to a formation of the metal-containing layer from the process chamber 201. That is, the inner atmosphere of the process chamber 201 is exhausted. Further, in the present step, by maintaining the valves 514, 524 and 534 open, the argon gas may be continuously supplied into the process chamber 201. In addition to serving as a gas capable of suppressing the metal-containing gas from entering each nozzle, the argon gas also serves as the purge gas. When the argon gas serving as the purge gas is supplied, it is possible to improve an efficiency of removing the residual gas in the process chamber 201 such as the metal-containing gas which remains unreacted or already contributed to a formation of the metal-containing layer from the process chamber 201.

### [Fifth Step]

### <Reducing Gas Supply Step>

After the residual gas in the process chamber 201 is removed in the fourth step, the valve 324 is opened to supply the reducing gas into the gas supply pipe 320. A flow rate of the reducing gas supplied into the gas supply pipe 320 is adjusted by the MFC 322. The reducing gas whose flow rate is adjusted is then supplied into the process chamber 201 through the gas supply holes 420a of the nozzle 420, and is exhausted through the exhaust pipe 231. Thereby, the reducing gas is supplied to the wafers 200. In the present step, by maintaining the valves 514, 524 and 534 open, the argon gas is continuously supplied into the gas supply pipes 510, 520 and 530. The flow rate of the argon gas supplied into the gas supply pipes 510, 520 and 530 is respectively adjusted by the MFCs 512, 522 and 532. The argon gas whose flow rate is adjusted by the MFC 522 is then supplied into the process chamber 201 together with the reducing gas through the gas supply pipe 320 and the nozzle 420, and is exhausted through the exhaust pipe 231. Further, the argon gas whose flow rate is adjusted by the MFC 532 is then supplied into the process chamber 201 through the gas supply pipe 330 and the nozzle 430, and is exhausted through the exhaust pipe 231. In addition, in order to prevent the reducing gas from entering the nozzle 410, the argon gas whose flow rate is adjusted by the MFC 512 is then supplied into the process chamber 201 through the gas supply pipe 310 and the nozzle 410, and is exhausted through the exhaust pipe 231.

In the present step, for example, the APC valve 243 is appropriately adjusted (or controlled) such that the inner pressure of the process chamber 201 can be set to a pressure within a range from 1 Pa to 13,300 Pa. For example, the inner pressure of the process chamber 201 is set to 5,000 Pa by adjusting the APC valve 243. For example, a supply flow rate of the reducing gas controlled by the MFC 322 can be set to a flow rate within a range from 1 slm to 50 slm, preferable from 15 slm to 40 slm. For example, each supply flow rate of the argon gas controlled by each of the MFCs 512, 522 and 532 can be set to a flow rate within a range from 0.1 slm to 5.0 slm. In the present step, for example, the temperature of the heater 207 can be set such that the temperature of the wafer 200 reaches and is maintained at a temperature within a range from 300 °C to 650 °C.

In the present step, the reducing gas serves as a primary gas (main gas) supplied into the process chamber 201. That is, the reducing gas is supplied to the wafers 200.

In the present step, as the reducing gas, for example, a gas constituted by hydrogen (H) may be used. Preferably, a gas constituted by a simple substance of hydrogen is used. Specifically, as the reducing gas, a gas such as hydrogen (H₂) gas and deuterium (D₂) gas may be used. Hereinafter, the present embodiments will be described by way of an example in which the H₂ gas is used as the reducing gas.

### [Sixth Step]

### <Residual Gas Removing Step>

After a predetermined time (for example, from 1 second to 1,200 seconds) has elapsed from a supply of the reducing gas, the valve 324 of the gas supply pipe 320 is closed to stop the supply of the reducing gas. Then, a residual gas in the process chamber 201 such as the reducing gas which did not react or which contributed to a formation of the metal-containing layer and reaction by-products are removed from the process chamber 201 in substantially the same manners as in the second step described above. That is, the inner atmosphere of the process chamber 201 is exhausted.

### <Performing a Predetermined Number of Times>

By performing a cycle (in which the third step through the sixth step described above are sequentially performed in this order) at least once (that is, a predetermined number of times (n times)), the Mo-containing film serving as the metal-containing film of a predetermined thickness is formed on the wafer 200. It is preferable that the cycle described above is repeatedly performed a plurality number of times. Further, the Mo-containing film refers to a film containing molybdenum as a main component, and a layer containing molybdenum (Mo) and phosphorus (P) is formed in the Mo-containing film adjacent to the wafer 200 (adjacent to the first layer). It is preferable that the phosphorus concentration in the Mo-containing film decreases toward a surface of the Mo-containing film.

### <After-purge Step and Returning to Atmospheric Pressure Step>

The argon gas is supplied into the process chamber 201 through each of the gas supply pipes 510, 520 and 530, and is exhausted through the exhaust pipe 231. The argon gas serves as the purge gas, and the inner atmosphere of the process chamber 201 is purged with the inert gas. Thus, the residual gas in the process chamber 201 and the reaction by-products remaining in the process chamber 201 are removed from the process chamber 201 (after-purge step). Thereafter, the inner atmosphere of the process chamber 201 is replaced with the inert gas (substitution by inert gas), and the inner pressure of the process chamber 201 is returned to a normal pressure (atmospheric pressure) (returning to atmospheric pressure step).

### <Wafer Unloading Step>

Thereafter, the seal cap 219 is lowered by the boat elevator 115 and the lower end of the outer tube 203 is opened. The boat 217 with the processed wafers 200 charged therein is unloaded out of the outer tube 203 through the lower end of the outer tube 203 (boat unloading step). Then, the processed wafers 200 are discharged (transferred) out of the boat 217 (wafer discharging step).

### (3) Effects according to Present Embodiments

According to the present embodiments, it is possible to obtain one or more of the following effects.
(a) By forming the first layer between the surface of the wafer 200 and the Mo-containing film, it is possible to improve an adhesion between the Mo-containing film and the wafer 200. Thereby, it is possible to form a metal-based film with desirable characteristics without forming a barrier film on the surface of the wafer 200.
(b) By incorporating the Group 15 element contained in the first layer into the Mo-containing film, it is possible to improve an adhesion with a film (based film) formed on the surface of the wafer 200. That is, it is possible to increase a bonding strength between the first layer and the surface of the wafer 200 and a bonding strength between the first layer and the Mo-containing film.
(c) By diffusing the Group 15 element contained in the first layer into the Mo-containing film, it is possible to improve a bonding strength of the element present in the Mo-containing film. That is, it is possible to generate a bond between molybdenum elements or between the Mo element and the Group 15 element.
(d) It is possible to increase the reactivity between the first layer and the Mo-containing gas serving as the metal-containing gas, and it is also possible to improve a film forming rate of the Mo-containing film. That is, it is possible to improve the productivity (throughput) of the semiconductor device. For example, a case will be described in which the PH₃ gas is used as the gas containing the Group 15 element and the MoO₂Cl₂ gas is used as the Mo-containing gas. In such a case, a layer containing the PHₓ is formed as the first layer. A chemical reaction may easily occur between the PHₓ and the MoO₂Cl₂. The PHₓ and the MoO₂Cl₂ react more easily than when the first layer is not formed on the surface of the wafer 200. Thereby, the layer containing molybdenum is formed on the wafer 200 (on its first layer), and a molecule containing phosphorus (P) is desorbed from the first layer. For example, a molecule containing phosphorus (P) such as phosphorus tetrachloride (P₂Cl₄) is desorbed from the first layer. Since such a reaction occurs, it is possible to improve the film forming rate of the Mo-containing film. In addition, such a chemical reaction causes the Group 15 element to be incorporated into the Mo-containing film (the Group 15 element diffuses into the Mo-containing film). It can be said that a part (surface) of the first layer is partially removed by the source gas (that is, the metal-containing gas). Further, it can also be said that the part (surface) of the first layer is partially decomposed by the source gas.
(e) When forming the first layer, even in a case where the temperature of the wafer 200 or a temperature of a structure around the wafer 200 (for example, at least one among the substrate support and the process vessel) is at a decomposition temperature of the Group 15 element-containing material, it is possible to suppress an excessive decomposition of the Group 15 element-containing material by supplying the dilution gas. That is, by supplying the dilution gas, it is possible to set a processing atmosphere for the wafer 200 (such as the inner pressure of the process chamber 201) to an atmosphere capable of suppressing the decomposition of the Group 15 element-containing material. Further, even when the Group 15 element-containing material is decomposed within the process chamber 201, by supplying the dilution gas, it is possible to suppress decomposition products from being excessively supplied to the wafer 200. That is, it is possible to obtain an effect of washing away the decomposition products by supplying the dilution gas. Further, the dilution gas is considered to be capable of suppressing the decomposition of the Group 15 element-containing material by lowering a partial pressure of the gas containing the Group 15 element. In addition, by lowering the partial pressure of the gas containing the Group 15 element, it is possible to lower a probability that the molecules of the gas containing the Group 15 element collide with the structure (for example, the substrate support or the process vessel) whose temperature is equal to or greater than the decomposition temperature. Thereby, it is considered that the molecules of the gas containing the Group 15 element can receive a thermal energy from the structure whose temperature is equal to or greater than the decomposition temperature, and as a result the probability of the decomposition can be reduced. For example, it is possible to obtain substantially the same effect not only with the partial pressure of the Group 15 element-containing gas but also with a total pressure of the Group 15 element-containing gas. Further, in the substrate processing apparatus provided with the heating structure around the process vessel as shown in FIG. 1, since the temperature of the structure around the wafer 200 may be higher than a set temperature of the wafer 200, an environment where the decomposition of the Group 15 element-containing material is likely to occur may be provided. Therefore, with such a configuration of the substrate processing apparatus, it is possible to obtain even more remarkable effects. Further, it is preferable that the partial pressure of the gas containing the Group 15 element in the process chamber 201 is set to be lower than a partial pressure of the inert gas serving as the dilution gas. By establishing such a partial pressure relationship, it is possible to suppress the decomposition of the gas containing the Group 15 element.
(f) When forming the first layer, even in a case where the temperature of the wafer 200 or the temperature of the structure around the wafer 200 (for example, at least one among the substrate support and the process vessel) is at the decomposition temperature of the Group 15 element-containing material, it is possible to suppress the excessive decomposition of the Group 15 element-containing material by supplying the reducing gas. That is, by supplying the reducing gas, it is possible to provide the atmosphere capable of suppressing the decomposition of the Group 15 element-containing material. It is considered that the reducing gas itself can provide substantially the same effect as the dilution gas, and also can provide an effect of suppressing a thermal decomposition of the Group 15 element-containing material. In order to obtain such an effect of directly suppressing the thermal decomposition of the Group 15 element-containing material by the reducing gas, it is preferable that both the Group 15 element-containing gas and the reducing gas contain the same element. As such an element, for example, hydrogen (H) may be used. Specifically, the materials exemplified above may be used. Further, it is preferable that the partial pressure of the gas containing the Group 15 element in the process chamber 201 is set to be smaller than a partial pressure of the reducing gas. By establishing such a partial pressure relationship, it is possible to suppress the decomposition of the gas containing the Group 15 element. In order to obtain such a partial pressure, for example, as shown in FIG. 4, the flow rate of the reducing gas may be set to be greater than the flow rate of the gas containing the Group 15 element.
(g) By forming the metal film (Mo-containing film) in the atmosphere capable of suppressing the decomposition of the first layer, it is possible to obtain one or more of the effects among (a), (b), (c) and (d) described above. The atmosphere capable of suppressing the decomposition of the first layer will be described in detail in modified examples.

### (4) Other Embodiments

Subsequently, the modified examples of the substrate processing of the embodiments described above will be described in detail. In the following modified examples, features different from the embodiments described above will be described in detail.

### <First Modified Example>

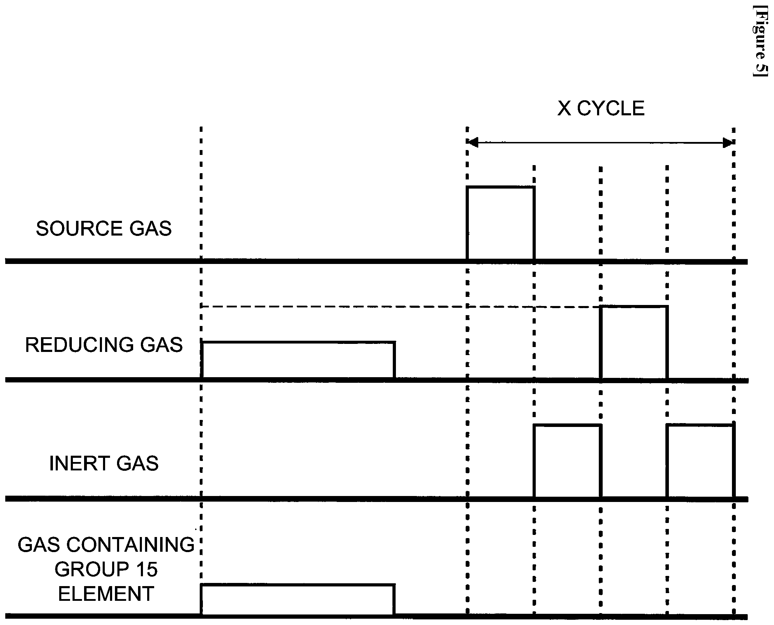

In the present modified example, as shown in FIG. 5, the supply flow rate of the reducing gas in the reducing gas supply step (which is the fifth step described above) is set to be higher than the supply flow rate of the reducing gas serving as the dilution gas supplied during the gas containing the Group 15 element supply step of the first step described above. By increasing the supply flow rate of the reducing gas in the fifth step in a manner described above, it is possible to increase a reduction amount of the molecules of the Mo-containing gas adsorbed on the wafer 200, and it is also possible to suppress the decomposition of the first layer. In the metal-containing film forming step including the fifth step, the temperature of the wafer 200 is set so as to promote the reaction between the Mo-containing gas adsorbed on the wafer 200 and the reducing gas. At such a temperature, although the reactivity between the Mo-containing gas and the reducing gas can be increased, there may be a problem that the first layer is decomposed. When the first layer decomposes, it is possible to form the Mo-containing film while removing the first layer. Thereby, it is possible to reduce impurities (for example, phosphorus (P)) in the Mo-containing film. However, there may be a problem that the adhesion between the Mo-containing film and the wafer 200 decreases. By increasing the flow rate of the reducing gas in a Mo-containing film forming step (that is, the metal-containing film forming step described above) as in the first modified example, it is possible to suppress the decomposition of the first layer. In the present specification, for example, the decomposition of the first layer may refer to the thermal decomposition of the first layer. Focusing on the PH₃ in the first layer, for example, a reaction of the decomposition is a reaction of "2PH₃ → 2P + 3H₂". It is possible to suppress such a reaction by increasing the flow rate of the reducing gas in the fifth step. Further, it is preferable that the flow rate of the reducing gas in the fifth step is set to be higher than the flow rate of the Mo-containing gas in the third step. In addition, by suppressing the decomposition of the first layer, it is possible to suppress (prevent) the element (for example, phosphorus (P)) contained in the first layer from being excessively incorporated into the Mo-containing film. In addition, when the impurities are excessively incorporated into the Mo-containing film, electrical characteristics (for example, resistivity) of the Mo-containing film may deteriorate.

### <Second Modified Example>

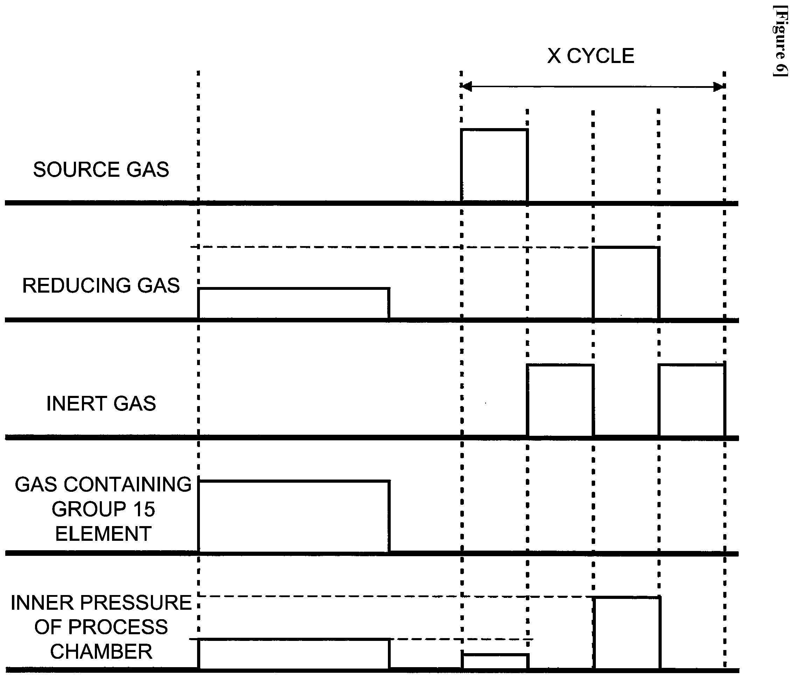

In the present modified example, as shown in FIG. 6, the inner pressure of the process chamber 201 in the fifth step is set to be higher than the inner pressure of the process chamber 201 in the first step. By setting the inner pressure of the process chamber 201 in a manner described above, similar to the first modified example, it is possible to suppress the decomposition of the first layer, which occurs in the metal-containing film forming step. Further, the inner pressure of the process chamber 201 in the first step may be set to be higher than the inner pressure of the process chamber 201 in the third step. In other words, the inner pressure of the process chamber 201 in the third step is set to be lower than the inner pressure of the process chamber 201 in the first step. Further, the inner pressure of the process chamber 201 in the third step is set to be lower than the inner pressure of the process chamber 201 in the fifth step. By setting the inner pressure of the process chamber 201 in a manner described above, it is possible to set (adjust) a reaction amount between the first layer and the metal-containing gas in the third step to be smaller than the reaction amount between the first layer and the reducing gas in the fifth step. That is, in the third step, it is possible to suppress the decomposition of the first layer due to the metal-containing gas. In addition, in the third step, the metal-containing gas can cause the metal element to cover a surface of the first layer with reduction, such that it is possible to suppress (prevent) the reducing gas supplied in the fifth step from reaching the surface of the first layer. That is, in the fifth step, it is possible to suppress the decomposition of the surface of the first layer by the reducing gas.

### <Third Modified Example>

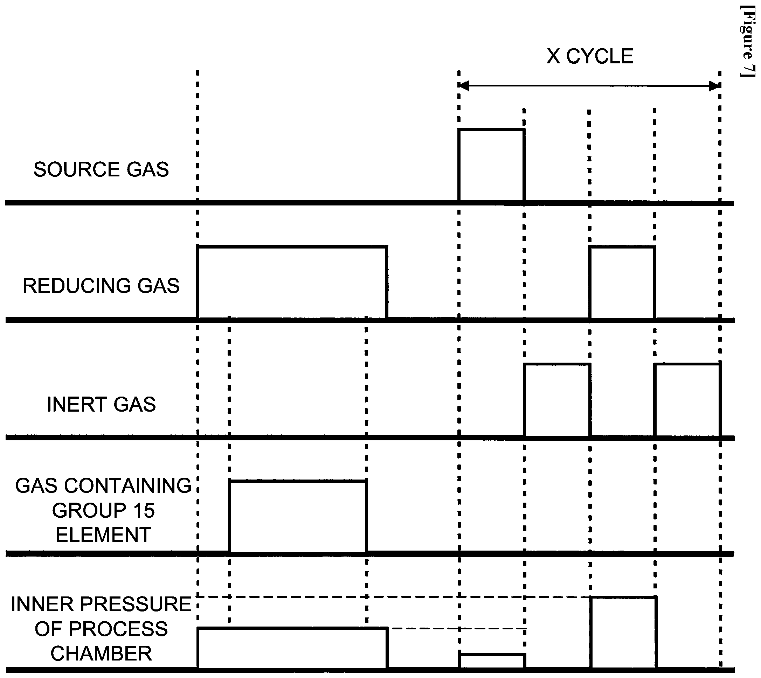

In the present modified example, as shown in FIG. 7, in the first step, the supply of the reducing gas is started before the supply of the gas containing the Group 15 element is started, and the supply of the gas containing the Group 15 element is stopped during the supply of the reducing gas.

By starting the supply of the reducing gas before starting the supply of the gas containing the Group 15 element, it is possible to suppress a possible decomposition reaction of the gas containing the Group 15 element immediately after the supply of the gas containing the Group 15 element is started. Further, before starting the supply of the gas containing the Group 15 element, it is preferable that the inner pressure of the process chamber 201 is increased to a predetermined pressure in advance by using the reducing gas. By increasing the inner pressure of the process chamber 201 to a predetermined level with the reducing gas, it is possible to disperse molecules of the reducing gas in the process chamber 201, and it is also possible to improve an establishment of contact between the molecules of the Group 15 element-containing material and the reducing gas in the process chamber 201. Thereby, it is possible to suppress the decomposition reaction of the Group 15 element-containing material.

Further, by stopping the supply of the gas containing the Group 15 element while the reducing gas is being supplied, it is possible to suppress the decomposition reaction of the gas containing the Group 15 element remaining in the process chamber 201. By suppressing the decomposition of the gas containing the Group 15 element remaining in the process chamber 201, it is possible to suppress (prevent) a simple substance of the Group 15 element (which is generated by the decomposition of the Group 15 element-containing material on the surface of the first layer formed in the first step) from being exposed on the surface of the wafer 200 (that is, on the first layer). It is preferable that the surface of the first layer is provided with the Group 15 element-containing material adsorbed thereon. By providing the surface of the first layer adsorbed with the Group 15 element-containing material, it is possible to promote the reaction between the Mo-containing gas supplied in the third step and the Group 15 element-containing material.

In addition, in the first step, it is possible to perform one of an operation of starting the supply of the reducing gas before the supply of the gas containing the Group 15 element is started and an operation of stopping the supply of the gas containing the Group 15 element during the supply of the reducing gas. By performing one of the operations described above, it is possible to obtain an effect related thereto. By performing both of the operations described above, it is possible to obtain effects related thereto.

### <Fourth Modified Example>

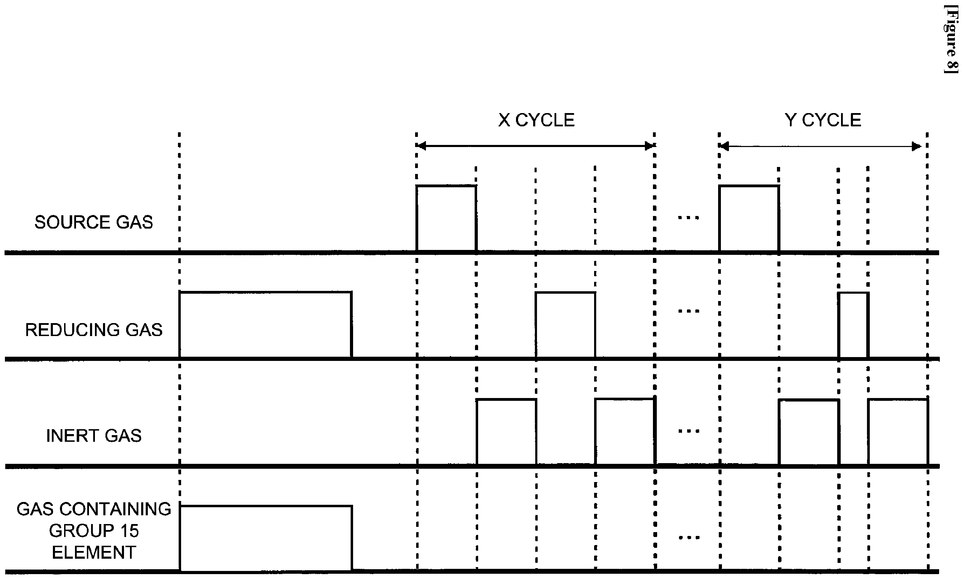

The present modified example, as shown in FIG. 8, includes a step in which the third step to the sixth step are performed X times and a step in which the third step to the sixth step are performed Y times. A supply time of the reducing gas in the fifth step (that is, the reducing gas supply step) in the step performed X times is set to be longer than the supply time of the reducing gas in the fifth step in the step performed Y times. With such a configuration, it is possible to suppress the decomposition of the first layer and to allow the first layer to remain on the wafer 200 in an early stage of forming the Mo-containing film. Further, by forming the Mo-containing layer to a certain extent, the Mo-containing layer formed in the early stage becomes a cap film for the first layer. Thereby, it is possible to prevent the first layer from being desorbed from the wafer 200 due to the thermal decomposition. In addition, each of X and Y in the present modified example is an integer of 1 or more.

For example, the embodiments described above are described by way of an example in which the MoO₂Cl₂ gas is used as the metal-containing gas (that is, the Mo-containing gas). However, the technique of the present disclosure is not limited thereto.

For example, the embodiments described above are described by way of an example in which the same type of gas is used as the reducing gas for the first step and the reducing gas for the fifth step. However, the technique of the present disclosure is not limited thereto. For example, a molecular structure of the reducing gas used in the first step may be different from that of the reducing gas used in the fifth step. For example, the hydrogen (H₂) gas may be used in the first step, and the deuterium (D₂) gas or an activated H₂ gas may be used in the fifth step. Further, in the fifth step, at least one selected from the group of the PH₃ gas, a silane-based gas described later and a borane-based gas described later may be used. In addition, as the reducing gas used in the first step, it is possible to use a gas whose characteristics include at least one among suppressing the decomposition of the Group 15 element-containing material and acting as a carrier for the Group 15 element-containing material. Further, as the reducing gas for the fifth step, it is possible to use a gas whose characteristics include at least one among reducing the Mo-containing gas serving as the source gas and suppressing the decomposition of the first layer.

For example, the embodiments described above are described by way of an example in which the gas containing phosphorus (P) and hydrogen (H) is used as the gas containing the Group 15 element. However, the technique of the present disclosure is not limited thereto. For example, another reducing gas may be used as the gas containing the Group 15 element. For example, as the gas containing the Group 15 element, the silane-based gas such as monosilane (SiH₄) gas, disilane (Si₂H₆) gas, trisilane (Si₃H₈) gas and tetrasilane (Si₄H₁₀) gas or the borane-based gas such as monoborane (BH₃) gas and diborane (B₂H₆) gas may be used. However, when the silane-based gas or the borane-based gas is used, it is difficult to obtain by-products that are easily desorbed, such as POCl₄ generated when the PH₃ is used. Thus, there is a risk that the characteristics of the Mo-containing film may deteriorate. Therefore, as the gas containing the Group 15 element, preferably, a gas containing phosphorus is used. More preferably, the gas containing phosphorus and hydrogen is used.

For example, the embodiments described above are described by way of an example in which the gas containing molybdenum (Mo) element is used as the source gas (that is, the metal-containing gas). However, the technique of the present disclosure is not limited thereto. For example, the technique of the present disclosure may also be applied when a gas containing at least one element selected from the group of ruthenium (Ru) and tungsten (W) is used as the source gas.

For example, the embodiments described above are described by way of an example in which a vertical batch type substrate processing apparatus configured to simultaneously process a plurality of substrates is used to form the film. However, the technique of the present disclosure is not limited thereto. For example, the technique of the present disclosure may be preferably applied when a single wafer type substrate processing apparatus configured to process one or several substrates at a time is used to form the film. Even when such a substrate processing apparatus is used to form the film, the process sequences and process conditions may be substantially the same as those of the embodiments described above.

It is preferable that the process recipe (that is, a program defining parameters such as the process sequences and the process conditions of the substrate processing) used to form various films described above is prepared individually in accordance with the contents of the substrate processing such as a type of the film to be formed, a composition ratio of the film, a quality of the film, a thickness of the film, the process sequences and the process conditions of the substrate processing. That is, a plurality of process recipes are prepared. Then, when starting the substrate processing, an appropriate process recipe is preferably selected among the process recipes in accordance with the contents of the substrate processing. Specifically, it is preferable that the process recipes are stored (installed) in the memory 121c of the substrate processing apparatus in advance via an electric communication line or the recording medium (for example, the external memory 123) storing the process recipes prepared individually in accordance with the contents of the substrate processing. Then, when starting the substrate processing, the CPU 121a preferably selects the appropriate process recipe among the process recipes stored in the memory 121c of the substrate processing apparatus in accordance with the contents of the substrate processing. With such a configuration, various films of different types, different composition ratios, different qualities and different thicknesses may be universally formed with a high reproducibility using a single substrate processing apparatus. In addition, since a burden on an operator such as inputting the process sequences and the process conditions may be reduced, various processes can be performed quickly while avoiding a misoperation of the apparatus.

Further, the technique of the present disclosure may be implemented by changing an existing process recipe stored in the substrate processing apparatus to a new process recipe. When changing the existing process recipe to the new process recipe, the new process recipe may be installed in the substrate processing apparatus via the electric communication line or the recording medium storing the process recipes. Alternatively, the existing process recipe already stored in the substrate processing apparatus may be directly changed to the new process recipe according to the technique of the present disclosure by operating the input/output device of the substrate processing apparatus.

The technique of the present disclosure is described in detail by way of the embodiments described above. However, the technique of the present disclosure is not limited thereto. The technique of the present disclosure may be modified in various ways without departing from the scope thereof.

### [Description of Reference Numerals]

| | | | |
|---|---|---|---|
| 10 | substrate processing apparatus | 121 | controller |
| 200 | wafer (substrate) | 201 | process chamber |

## Claims

1. A method of manufacturing a semiconductor device, comprising:
(a) forming a first layer containing a Group 15 element on a surface of a substrate by supplying a gas containing the Group 15 element to the substrate;
(b) supplying a gas containing molybdenum to the substrate;
(c) supplying a reducing gas to the substrate; and
(d) forming a film containing molybdenum on the first layer by performing (b) and (c) a predetermined number of times in an atmosphere capable of suppressing a decomposition of the first layer.

2. The method of claim 1, wherein, in (a), a processing atmosphere for the substrate is set to an atmosphere capable of suppressing a decomposition of a Group 15 element-containing material contained in the gas containing the Group 15 element.

3. The method of claim 1 or 2, wherein, in (a), a reducing gas is supplied at least while the gas containing the Group 15 element is being supplied.

4. The method of claim 3, wherein a flow rate of the reducing gas supplied in (c) is set to be greater than a flow rate of the reducing gas supplied in (a).

5. The method of claim 3 or 4, wherein a pressure of a processing atmosphere for the substrate in (c) is set to be higher than the pressure of the processing atmosphere for the substrate in (a).

6. The method of claim 3 or 4, wherein, in (a), a partial pressure of the gas containing the Group 15 element in a processing atmosphere for the substrate is set to be lower than at least one of a partial pressure of the reducing gas or a partial pressure of an inert gas supplied to the processing atmosphere for the substrate.

7. The method of claim any one of claims 3 through 6, wherein, in (a), a supply of the reducing gas is started before a supply of the gas containing the Group 15 element is started.

8. The method of claim any one of claims 3 through 7, wherein, in (a), a pressure of a processing atmosphere for the substrate is increased by the reducing gas before a supply of the gas containing the Group 15 element is started.

9. The method of any one of claims 3 through 8, wherein, in (a), a supply of the gas containing the Group 15 element is stopped while the reducing gas is being supplied.

10. The method of any one of claims 3 through 9, wherein the reducing gas contains hydrogen.

11. The method of any one of claims 3 through 10, wherein the reducing gas is constituted by a simple substance of hydrogen.

12. The method of any one of claims 3 through 10, wherein a molecular structure of the reducing gas supplied in (a) is set to be different from that of the reducing gas supplied in (c).

13. The method of any one of claims 3 through 9, wherein (d) comprises:
performing (b) and (c) X times; and
performing (b) and (c) Y times after performing (b) and (c) X times, where each of X and Y is an integer greater than or equal to 1,
wherein a process time of (c) during performing (b) and (c) X times is set to be longer than a process time of (c) during performing (b) and (c) Y times.

14. The method of any one of claims 1 through 13, wherein a pressure of a processing atmosphere for the substrate in (c) is set to be higher than the pressure of the processing atmosphere for the substrate in (b).

15. The method of any one of claims 1 through 14, wherein a temperature of the substrate in (a) is set to be equal to or lower than the temperature of the substrate in (c).

16. The method of any one of claims 1 through 15, wherein, in (a), a concentration of the gas containing the Group 15 element supplied to the substrate is set to be within a range from of 0.1 % to 50 %.

17. The method of any one of claims 1 through 16, wherein the gas containing the Group 15 element contains phosphorus.

18. The method of any one of claims 1 through 17, wherein the gas containing the Group 15 element contains hydrogen.

19. A substrate processing method comprising:
(a) forming a first layer containing a Group 15 element on a surface of a substrate by supplying a gas containing the Group 15 element to the substrate;
(b) supplying a gas containing molybdenum to the substrate;
(c) supplying a reducing gas to the substrate; and
(d) forming a film containing molybdenum on the first layer by performing (b) and (c) a predetermined number of times in an atmosphere capable of suppressing a decomposition of the first layer.

20. A substrate processing apparatus comprising:
a process vessel in which a substrate is processed;
a gas supplier through which at least one selected from the group consisting of a gas containing molybdenum, a reducing gas and a gas containing a Group 15 element is supplied to a substrate;
an exhauster through which an inner atmosphere of the process vessel is exhausted; and
a controller configured to be capable of controlling the gas supplier so as to perform:
(a) forming a first layer containing the Group 15 element on a surface of the substrate by supplying the gas containing the Group 15 element to the substrate;
(b) supplying the gas containing molybdenum to the substrate;
(c) supplying the reducing gas to the substrate; and
(d) forming a film containing molybdenum on the first layer by performing (b) and (c) a predetermined number of times in an atmosphere capable of suppressing a decomposition of the first layer.

21. A non-transitory computer-readable recording medium storing a program that causes a substrate processing apparatus, by a computer, to perform:
(a) forming a first layer containing a Group 15 element on a surface of a substrate by supplying a gas containing the Group 15 element to the substrate;
(b) supplying a gas containing molybdenum to the substrate;
(c) supplying a reducing gas to the substrate; and
(d) forming a film containing molybdenum on the first layer by performing (b) and (c) a predetermined number of times in an atmosphere capable of suppressing a decomposition of the first layer.
